# DEMANDE DE BREVET EUROPEEN

(11) **EP 3 182 221 A1**
(43) Date de publication de la demande: **21.06.2017**
(21) Numéro de dépôt: 15200076.6
(22) Date de dépôt: 15.12.2015
(51) Int. Cl.: G04B 47/06, G04G 21/02, A44C 5/00

(54) **BRACELET DE MONTRE**

(71) Demandeur: Omega SA, 2502 Bienne (CH)
(72) Inventeur: Nicolas, Cédric, 2000 Neuchâtel (CH); Fostinis, Dimitri, 2740 Moutier (CH)
(74) Mandataire: Supper, Marc

(57) **Abrégé**

Bracelet pour boîte de montre (8) comprenant un premier bras (58) dans lequel est logée une première portion de circuit imprimé (4) et un second bras (60), le premier bras (58) étant prolongé par une partie médiane (6) agencée pour se trouver sous la boîte de montre (8) et qui comprend une deuxième portion de circuit imprimé (10) reliée à la première portion de circuit imprimé (4) par des moyens de connexion électriques, la première portion de circuit imprimé (4) portant au moins une source d'énergie électrique (38) et un microcontrôleur (30) pour l'alimentation et la commande d'un capteur de pression (32), la partie médiane (6) étant coiffée par un insert (16) agencé pour servir de siège à la boîte de montre (8), un logement (50) dans lequel est agencé le capteur de pression (32) étant ménagé dans l'insert (16) et communiquant avec l'extérieur afin de permettre la mise en contact du capteur de pression (32) avec le milieu environnant, le capteur de pression (32) étant monté sur la deuxième portion de circuit imprimé (10) avec interposition d'un joint d'étanchéité (54) entre le logement (50) et la deuxième portion de circuit imprimé (10).

## Description

### Domaine technique de l'invention

La présente invention concerne un bracelet de montre. Plus précisément, l'invention concerne un bracelet de montre dans lequel sont logés un ou plusieurs composants électroniques agencés pour réaliser au moins une fonction électronique.

### Arrière-plan technologique de l'invention

Une tendance forte du marché actuel est relative aux montres connectées embarquant une ou plusieurs fonctions électroniques et capables de communiquer par exemple avec un téléphone portable de type smartphone. Dans le cas des montres connectées, l'accent est cependant mis davantage sur la palette de fonctions électroniques que de telles montres offrent à leurs utilisateurs que sur les qualités esthétiques, horométriques et d'étanchéité de telles montres. Les montres connectées actuellement disponibles sur le marché sont donc des objets peu esthétiques et relativement fragiles dont l'utilisation au quotidien requiert beaucoup de soin de la part de leurs porteurs.

Parmi les fonctions électroniques disponibles, il peut être envisagé de prévoir un capteur de pression pour permettre à l'utilisateur d'enregistrer les paramètres d'une plongée (temps de plongée, profondeur atteinte, températures), puis de sauvegarder l'historique de sa plongée dans un smartphone ou sur un ordinateur personnel. Le capteur de pression peut éventuellement être logé dans le bracelet de la montre, ceci afin de ne pas devoir modifier la boîte de la montre à l'intérieur de laquelle est logé un mouvement d'horlogerie qui peut être indifféremment de type mécanique, électronique ou électromécanique. La boîte de montre conserve donc intactes ses propriétés d'étanchéité, horométriques et esthétiques, tout en offrant à son utilisateur, grâce à l'ajout du bracelet, des fonctions électroniques supplémentaires.

L'intégration d'un capteur de pression dans un bracelet pose cependant un problème. Il faut en effet que le capteur de pression soit en contact avec le milieu dont la pression est à mesurer. Dans le cas d'une montre de plongée, il faut donc que le capteur de pression soit en contact avec l'eau, ce qui pose de sérieux problèmes notamment en termes d'étanchéité. En effet, si le capteur de pression est logé dans le bracelet, il faut prévoir dans celui-ci un orifice pour que le capteur de pression puisse être en contact avec l'eau. Les bracelets des montres connectées étant le plus souvent en élastomère, il faut donc que l'orifice soit prévu dès le moment du moulage de la matière élastomère, ou bien qu'il soit découpé dans la matière élastomère après moulage. Dans les deux cas, cela exige un positionnement extrêmement précis des différents composants du bracelet qu'il est très difficile à atteindre dans le cas d'une production industrielle et nécessite de devoir étanchéifier l'orifice, typiquement par collage, ce qui pose notamment des problèmes de fiabilité dans le temps. En effet, le bracelet subit constamment des mouvements de flexion et de torsion pour s'adapter à la forme et aux mouvements du poignet de l'utilisateur et est soumis à des pressions élevées durant les plongées sous-marines. L'orifice risque donc de perdre de son étanchéité, ce qui peut conduire à la destruction des composants électroniques logés dans le bracelet de la montre.

### Résumé de l'invention

La présente invention a pour but de remédier aux problèmes mentionnés ci-dessus ainsi qu'à d'autres encore en procurant un bracelet qui va permettre d'associer à une boîte de montre une fonction de mesure des paramètres d'une plongée sous-marine.

A cet effet, la présente invention concerne un bracelet pour boîte de montre comprenant un premier bras dans lequel est logée une première portion de circuit imprimé et un second bras, le premier bras étant prolongé par une partie médiane agencée pour se trouver sous la boîte de montre et qui comprend une deuxième portion de circuit imprimé reliée à la première portion de circuit imprimé par des moyens de connexion électriques, la première portion de circuit imprimé portant au moins une source d'énergie électrique et un microcontrôleur pour l'alimentation et la commande d'un capteur de pression, la partie médiane étant coiffée par un insert rigide agencé pour servir de siège à la boîte de montre, un logement dans lequel est agencé le capteur de pression étant ménagé dans l'insert et communiquant avec l'extérieur afin de permettre la mise en contact du capteur de pression avec le milieu environnant, le capteur de pression étant monté sur la deuxième portion de circuit imprimé avec interposition d'un joint d'étanchéité entre le logement et la deuxième portion de circuit imprimé.

Selon une caractéristique complémentaire de l'invention, une troisième portion de circuit imprimé logée dans le second bras et portant au moins un autre composant électronique est reliée à la première portion de circuit imprimé logée dans le premier bras via la deuxième portion de circuit imprimé.

Selon une autre caractéristique de l'invention, les première, deuxième et troisième portions de circuit imprimé sont faites d'un seul tenant.

Selon encore une autre caractéristique de l'invention, la partie médiane comprend au moins une arche.

Grâce à ces caractéristiques, la présente invention procure un bracelet pour une boîte de montre dans lequel est logé un capteur de pression pour la mesure de la pression lors d'une plongée sous-marine. Le fait que le capteur de pression soit agencé dans l'insert lui procure un logement rigide qu'il est possible de rendre étanche au moyen d'un simple joint d'étanchéité. Ainsi, les risques que les composants électriques et électroniques logés dans le bracelet soient endommagés ou détruits par une arrivée d'eau sont supprimés. D'autre part, pour le montage du capteur de pression, il suffit de fixer celui-ci sur la deuxième feuille de circuit imprimé, puis d'orienter convenablement l'insert et de coiffer cette deuxième feuille de circuit imprimé avec l'insert, en veillant à ce que le capteur de pression pénètre dans le logement prévu dans l'insert. On constate ainsi que les opérations de montage du capteur de pression sont très simples et peuvent être facilement automatisées. Enfin, comme le capteur de pression est mis en contact avec l'eau via le logement ménagé dans l'insert, il n'y a là non plus aucun risque de détérioration sous l'effet de la pression de l'eau ou de la déformation du bracelet.

Si le bracelet est usé ou si la source d'énergie électrique qu'il renferme est épuisée, il peut être facilement échangé pour un bracelet neuf. Bien entendu, selon une variante, la source d'énergie électrique peut aussi être rechargeable ou remplaçable.

Selon un avantage additionnel de l'invention, le fait que des feuilles de circuit imprimé soient disposées dans les deux brins du bracelet et que ces feuilles de circuit imprimé soient en outre électriquement reliées entre elles permet au choix d'augmenter le nombre de composants électroniques logés dans le bracelet et donc d'accroître le nombre de fonctions électroniques mises à la disposition de l'utilisateur, ou bien de répartir de manière optimale les composants électroniques entre les deux brins de bracelet.

### Brève description des figures

D'autres caractéristiques et avantages de la présente invention ressortiront plus clairement de la description détaillée qui suit d'un mode de réalisation du bracelet selon l'invention, cet exemple étant donné à titre purement illustratif et non limitatif seulement, en liaison avec le dessin annexé sur lequel :
- la figure 1 est une vue en perspective et à l'état dissocié du bracelet selon l'invention dans laquelle une première feuille de circuit imprimé est reliée à une troisième feuille de circuit imprimé via une partie médiane agencée pour se trouver sous une boîte de montre, cette partie médiane comprenant des moyens pour assurer la continuité électrique entre la première feuille de circuit imprimé et la troisième feuille de circuit imprimé et étant coiffée par un insert rigide qui sert de siège à la boîte de montre ;

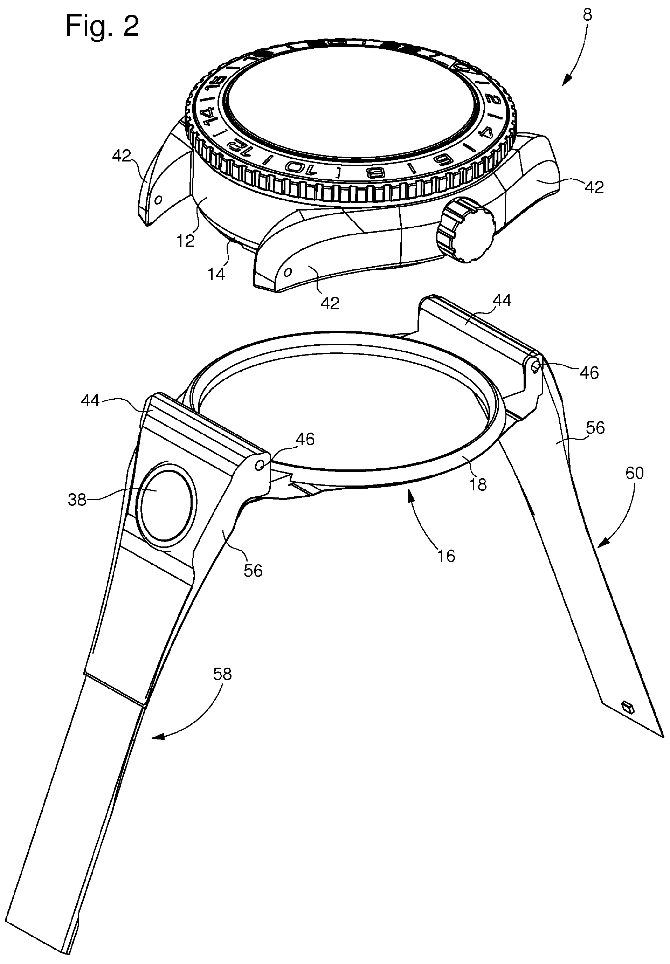

- la figure 2 est une vue analogue à celle de la figure 1 dans laquelle la première feuille de circuit imprimé et la troisième feuille de circuit imprimé sont surmoulées au moyen d'un premier matériau plastique ou élastomère ;
- la figure 3A est une vue en coupe verticale selon l'axe longitudinal du bracelet de la figure 2 ;
- la figure 3B est une vue à plus grande échelle de la région entourée d'un cercle sur la figure 3A ;
- la figure 4 est une vue d'un fourreau dans lequel est inséré le bracelet de la figure 2 ;
- les figures 5A et 5B illustrent le cas dans lequel le fourreau de la figure 4 comprend une bande supérieure et une bande inférieure entre lesquelles est disposé le bracelet selon l'invention et qui sont assemblées l'une à l'autre le long de leurs bords périphériques par exemple par couture ou par thermo-soudage ;
- la figure 6 illustre le cas où la partie médiane ne comprend qu'une seule arche pour supporter les pistes conductrices permettant de relier électriquement entre elles les première et troisième portions de circuit imprimé ;
- la figure 7 est une vue de détail à plus grande échelle de l'un des éléments de guidage de l'insert à l'intérieur duquel est logé le capteur de pression avec interposition d'un joint d'étanchéité, et
- la figure 8 est une vue de détail à plus grande échelle de l'autre élément de guidage à l'intérieur duquel est logé un guide pour conduire vers l'extérieur la lumière produite par une source de lumière ponctuelle.

### Description détaillée d'un mode de réalisation de l'invention

La présente invention procède de l'idée générale inventive qui consiste à associer à une boîte de montre renfermant un mouvement d'horlogerie préférentiellement mais non limitativement mécanique un bracelet dans l'épaisseur duquel sont logés au moins une source d'énergie électrique et un microcontrôleur pour l'alimentation et la commande d'un capteur de mesure de pression sous-marine. Ce capteur de pression doit permettre à un utilisateur de sauvegarder les historiques de ses plongées (temps de plongée, profondeur, température) pour ensuite les transférer vers un téléphone portable ou un ordinateur personnel. A cet effet, le bracelet selon l'invention comprend un premier bras dans lequel est logée une première portion de circuit imprimé et qui est prolongé par une partie médiane agencée pour se trouver sous la boîte de la montre et qui comprend une deuxième portion de circuit imprimé reliée à la première portion de circuit imprimé par des moyens de connexion électriques. La première portion de circuit imprimé porte au moins une source d'énergie électrique et un microcontrôleur pour l'alimentation et la commande du capteur de pression, tandis que la partie médiane est coiffée par un insert rigide qui sert de siège à la boîte de montre et dans lequel sont ménagés deux éléments pour le guidage des barrettes qui permettent la fixation du bracelet sur la boîte de montre. Dans le volume de l'un de ces éléments de guidage est ménagé un logement à l'intérieur duquel est agencé le capteur de pression. Ce logement débouche d'une part sur la partie médiane pour permettre la fixation du capteur de pression sur la deuxième portion de circuit imprimé, et d'autre part dans le trou de passage de la barrette pour la mise en communication du capteur de pression avec l'eau. Un simple joint d'étanchéité permet d'isoler efficacement les composants électroniques logés dans le bracelet de l'eau. D'autre part, du fait que le capteur de pression est disposé dans un logement rigide, il n'y a aucun risque que le système de mesure de la pression se détériore en raison des déformations subies par le bracelet lorsqu'il est porté au poignet de son utilisateur.

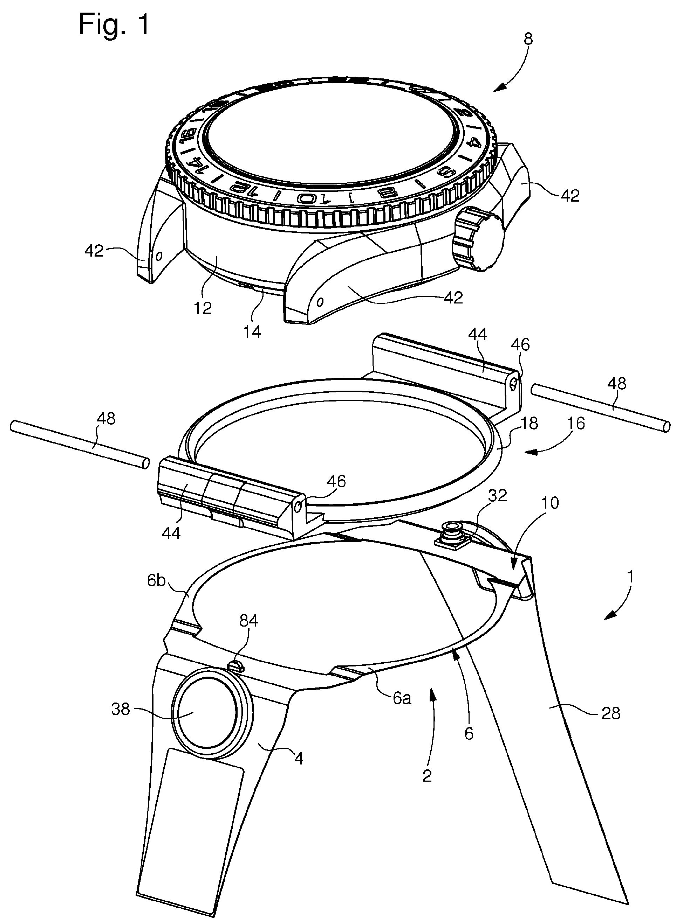

La figure 1 est une vue en perspective et à l'état dissocié du bracelet selon l'invention. Désigné dans son ensemble par la référence numérique générale 1, ce bracelet comprend une feuille de circuit imprimé 2 formée d'une première portion de circuit imprimé 4 prolongée par une partie médiane 6 agencée pour se trouver sous une boîte de montre 8 et qui comprend une deuxième portion de circuit imprimé 10 reliée à la première portion de circuit imprimé 4 par des moyens de connexion électrique qui assurent la continuité électrique entre la première portion de circuit imprimé 4 et la deuxième portion de circuit imprimé 10.

La deuxième portion de circuit imprimé 10 pourrait être électriquement séparée de la première portion de circuit imprimé 4. Dans ce cas, il faudrait cependant prévoir des moyens de connexion électrique entre la première portion de circuit imprimé 4 et la deuxième portion de circuit imprimé 10 tels que des fils, ce qui n'est pas nécessairement très commode ni très solide. C'est pourquoi, selon le mode préféré de réalisation de l'invention, la première portion de circuit imprimé 4 et la deuxième portion de circuit imprimé 10 sont faites d'un seul tenant. La partie médiane 6 est ainsi également constituée d'une portion de feuille de circuit imprimé sur laquelle sont structurées la ou les pistes électriquement conductrices permettant d'assurer la continuité électrique avec la première portion de circuit imprimé 4.

Comme il ressort en particulier de la figure 1, la partie médiane 6, de forme approximativement annulaire, est formée de deux arches 6a et 6b qui définissent un diamètre extérieur correspondant sensiblement au diamètre extérieur de la boîte de montre 8 qui est délimitée par une carrure 12 et un fond 14. La boîte de montre 8 est destinée à être disposée au-dessus de la partie médiane 6 avec interposition d'un insert 16 entre la boîte de montre 8 et la partie médiane 6. Cet insert 16 comprend un anneau rigide 18 dont la géométrie est semblable à celle de la partie médiane 6 et qui est fixé sur cette partie médiane 6 par tout moyen approprié tel que collage. Cet anneau rigide 18 confère à la partie médiane 6 rigidité et résistance mécanique et sert de siège à la boîte de montre 8. On comprend que, du fait de sa forme en anneau, la partie médiane 6 laisse visible le fond 14 de la boîte de montre 8.

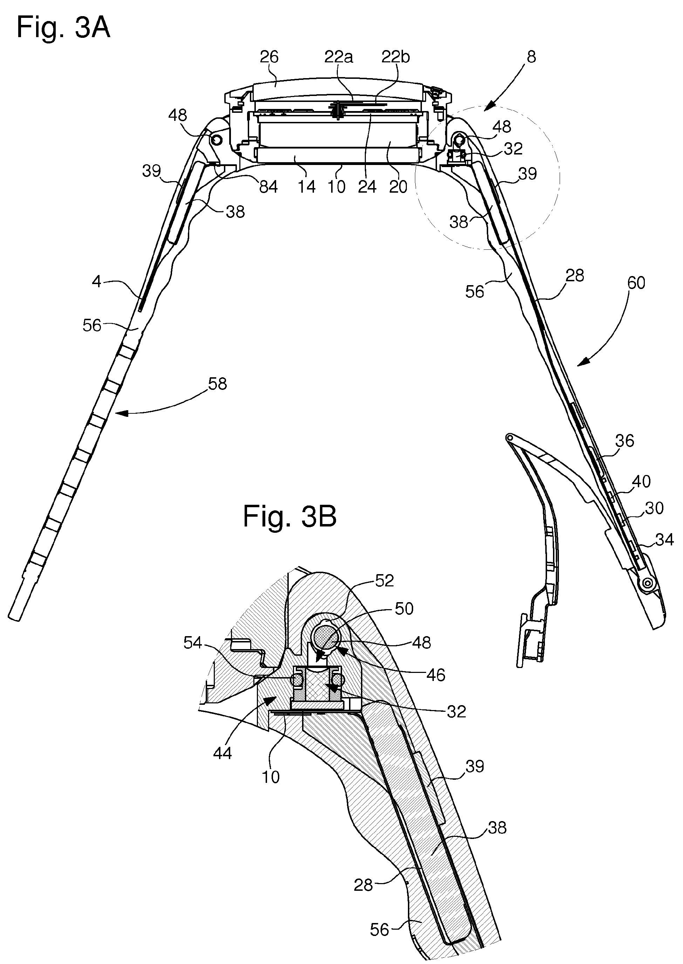

On examine maintenant le bracelet 1 selon l'invention en se référant plus particulièrement à la figure 3A qui est une vue en coupe selon un plan s'étendant selon l'axe longitudinal du bracelet 1. Comme il ressort de cette figure, la boîte de montre 8 renferme un mouvement horloger 20 qui entraîne un jeu d'aiguilles des heures 22a et des minutes 22b. Ces aiguilles d'heures 22a et de minutes 22b se déplacent au-dessus d'un cadran 24 et sont recouvertes par une glace 26.

Il est important de comprendre que le mouvement horloger 20 logé dans la boîte de montre 8 peut être de tout type. Il peut s'agir d'un mouvement purement mécanique, ou bien d'un mouvement purement électronique, ou bien encore d'un mouvement électromécanique. La nature mécanique ou électronique du mouvement horloger 20 est en fait sans aucune importance pour les besoins de la présente invention étant donné que la boîte de montre 8 est totalement indépendante du bracelet 1 selon l'invention et que l'ajout d'un tel bracelet 1 ne nécessite aucune modification des divers composants logés dans la boîte de montre 8.

On comprend donc de ce qui précède que la présente invention est intéressante en particulier dans le cas où le mouvement horloger 20 est un mouvement mécanique. En effet, l'adjonction à une boîte de montre 8 renfermant un tel mouvement horloger 20 purement mécanique d'un bracelet 1 selon l'invention permet de proposer à l'utilisateur des fonctions électroniques inédites sans aucunement altérer l'aspect esthétique, les qualités mécaniques et l'étanchéité de la boîte de montre 8.

Comme mentionné ci-avant, le bracelet 1 selon l'invention comprend une feuille de circuit imprimé 2 formée d'une première portion de circuit imprimé 4 qui, de préférence, est faite d'un seul tenant avec la partie médiane 6 qui comprend une deuxième portion de circuit imprimé 10 sur laquelle sont structurées la ou les pistes électriquement conductrices permettant d'assurer la continuité électrique avec la première portion de circuit imprimé 4. On comprendra plus loin dans la présente description qu'un tel agencement de circuits imprimés serait suffisant pour les besoins de la présente invention. Cependant, selon un mode préféré de réalisation de l'invention, le bracelet 1 comprend une troisième portion de circuit imprimé 28 qui est électriquement connectée à la première portion de circuit imprimé 4 via la partie médiane 6 et qui est faite d'une seule pièce avec ces dernières. Un tel agencement présente de nombreux avantages parmi lesquels on peut citer la possibilité de disposer davantage de composants électroniques dans le bracelet et donc d'accroître le nombre de fonctions électroniques mises à la disposition de l'utilisateur, ou bien de répartir de manière optimale les composants électroniques entre les deux brins de bracelet. En particulier, il est envisageable de monter la ou les sources d'énergie électrique sur l'une des feuilles de circuit imprimé, et les composants électroniques sur l'autre feuille de circuit imprimé. On comprendra également que le fait de disposer de davantage de place permet au concepteur d'optimiser l'ergonomie et les interactions entre l'utilisateur et le bracelet.

Comme visible à l'examen de la figure 3A, des composants électroniques tels qu'un microcontrôleur 30 pour la commande d'un capteur de pression 32, un accéléromètre 34 ainsi qu'un capteur magnétique 36 sont montés à la surface de la troisième portion de circuit imprimé 28. Ces composants électroniques sont alimentés par une source d'énergie électrique 38 elle aussi montée sur la troisième portion de circuit imprimé 28 et coiffée par un bouton-poussoir 39. De même, une source d'énergie électrique 38 coiffée par un autre bouton-poussoir 39 est montée à la surface de la première portion de circuit imprimé 4. Enfin, un circuit intégré 40 apte à communiquer avec un autre appareil en utilisant par exemple une interface de type Bluetooth, Wifi ou NFC est monté sur la troisième portion de circuit imprimé 28.

On voit notamment à l'examen de la figure 1 que la boîte de montre 8 comprend deux paires de cornes 42 diamétralement opposées et l'insert 16 comprend deux éléments de guidage 44 agencés pour se placer entre les paires de cornes 42 respectives lorsque la boîte de montre 8 est placée sur l'insert 16. Ces deux éléments de guidage 44 sont percés chacun d'un trou 46 pour le passage d'une barrette 48 permettant de fixer le bracelet 1 à la boîte de montre 8.

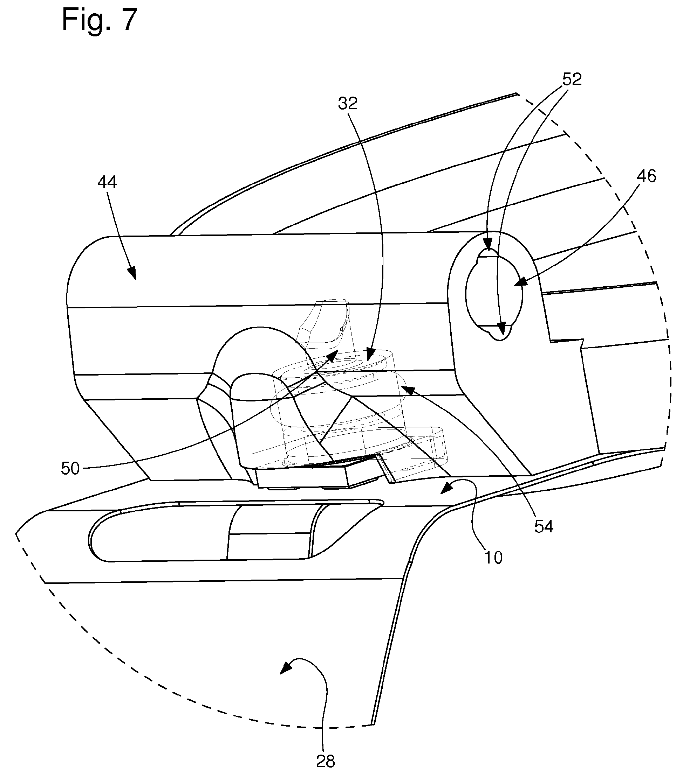

Conformément à la présente invention et comme visible notamment sur les figures 3B et 7, un logement 50 ménagé dans le volume de l'un des éléments de guidage 44 permet de recevoir le capteur de pression 32. Ce logement 50 débouche d'une part sur la partie médiane 6 pour permettre la fixation du capteur de pression 32 sur la deuxième portion de circuit imprimé 10 et sa connexion avec le microcontrôleur 30, et d'autre part dans le trou 46 de passage de la barrette 48 pour la mise en communication du capteur de pression 32 avec l'eau. On voit en effet que le trou 46 pour le passage de la barrette 48 présente localement une augmentation de diamètre 52 qui ne nuit pas au bon guidage de la barrette 48 mais qui permet de matérialiser un chemin pour amener l'eau en contact avec le capteur de pression 32. Un simple joint d'étanchéité 54 permet d'étanchéifier le logement 50 et d'isoler efficacement les composants électroniques logés dans le bracelet 1 de l'eau. D'autre part, du fait que le capteur de pression 32 est disposé dans un logement 50 rigide, il n'y a aucun risque que le système de mesure de la pression se détériore en raison des déformations subies par le bracelet 1 lorsqu'il est porté au poignet de son utilisateur. Le capteur de pression 32 est par exemple celui commercialisé par la société Measurement Specialities Inc. sous la référence MS5837-30BA. Il s'agit d'un capteur de pression de type piézorésistif dont l'élément sensible à la pression est formé par des jauges de contrainte montées en pont de Wheastone afin de maximiser le signal de sortie du capteur et minimiser sa sensibilité aux erreurs de mesure.

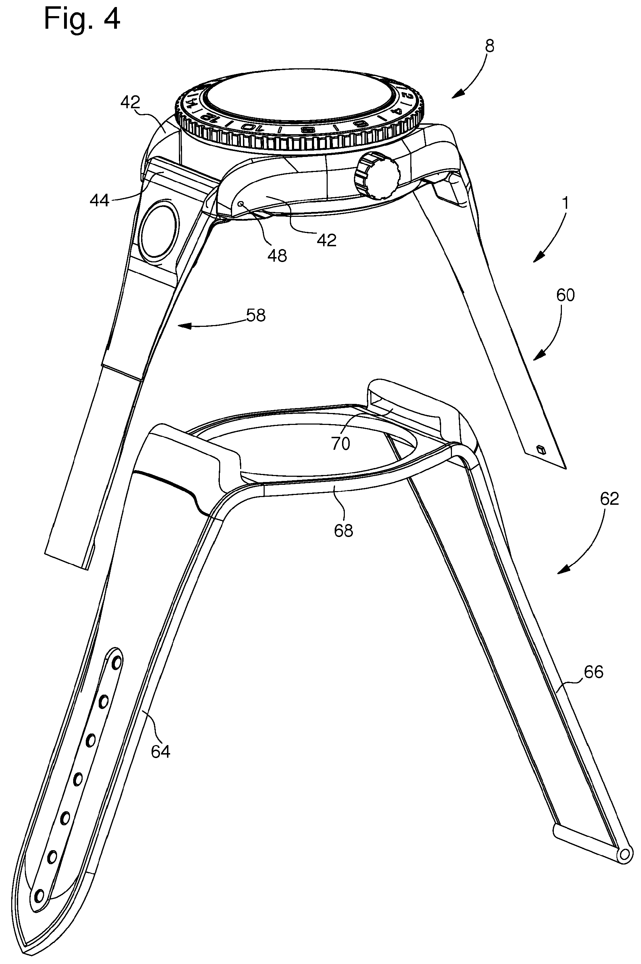

Lorsque l'ensemble des composants électroniques est monté sur la feuille de circuit imprimé 2 et que l'insert 16 a été convenablement disposé sur la partie médiane 6, on surmoule le tout avec une première couche 56 d'un matériau plastique ou élastomère afin de former des premier et second bras 58 et 60 (voir figure 4). Cette première couche de surmoulage 56 a pour but de protéger les composants électroniques montés sur les première et troisième portions de circuit imprimé 4, 28 des agressions extérieures et de conférer aux bras 58 et 60 résultants leur forme et leur tenue mécanique. De préférence, les barrettes 48 sont engagées à travers les cornes 42 et les éléments de guidage 44 au moment de l'opération de surmoulage afin d'éviter que les trous 46 ne soient obstrués par la matière de surmoulage.

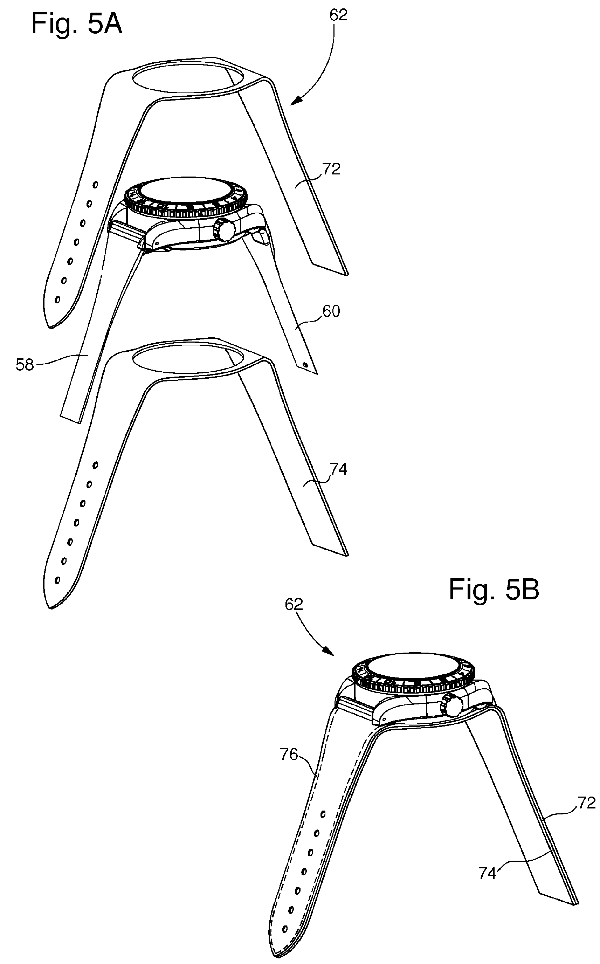

Le bracelet 1 qui résulte de l'opération de surmoulage et qui comprend les deux bras 58, 60 reliés entre eux par la partie médiane 6 coiffée par l'insert 16 et dans l'épaisseur desquels sont logés les composants électroniques nécessaires à la réalisation de la ou des fonctions électroniques recherchées est finalement glissé dans un fourreau 62 qui, dans l'exemple représenté à la figure 4, comprend un premier brin 64 et un second brin 66 reliés entre eux par une partie de raccordement 68 qui est adaptée en forme et en dimension pour recevoir la partie médiane 6 du bracelet 1 coiffée par l'insert 16. Ce fourreau 62 est par exemple obtenu par moulage ou injection d'un matériau élastomère en veillant à ce que les premier et second brins 64 et 66 soient creux et pourvus chacun d'une ouverture 70 afin de pouvoir y glisser les deux bras 58 et 60. Selon une variante de réalisation illustrée aux figures 5A et 5B, le fourreau 62 comprend une bande supérieure 72 et une bande inférieure 74 entre lesquelles est disposé le bracelet 1 selon l'invention et qui sont assemblées l'une à l'autre le long de leurs bords périphériques 76 par exemple par couture ou par thermo-soudage.

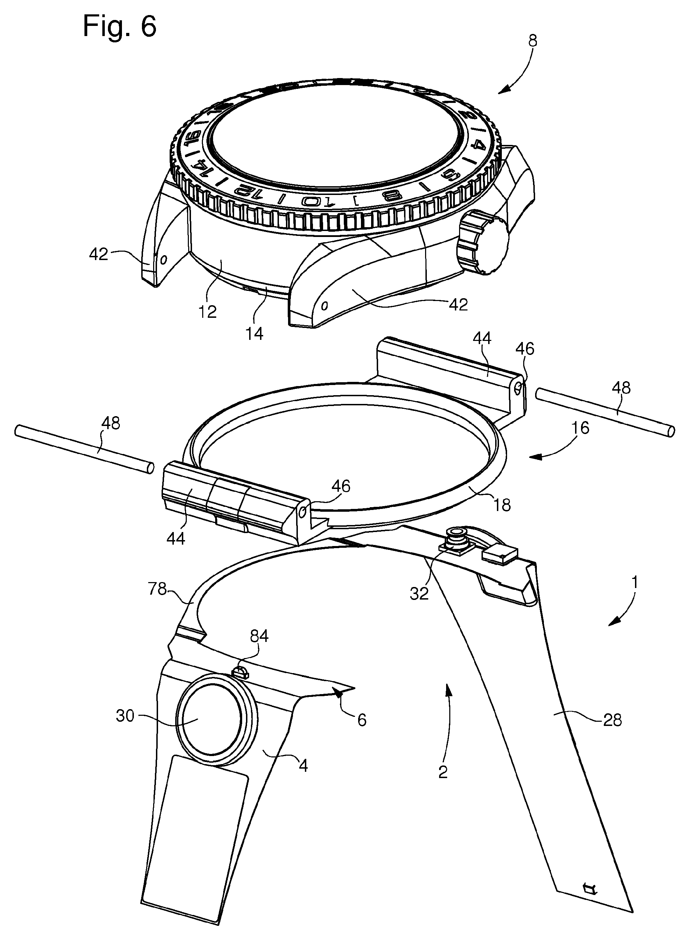

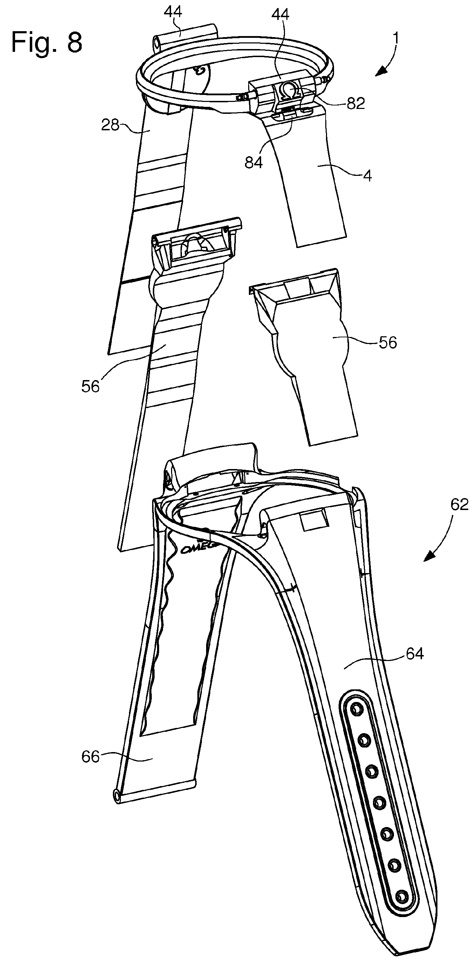

Il va de soi que la présente invention n'est pas limitée au mode de réalisation qui vient d'être décrit et que diverses modifications et variantes simples peuvent être envisagées par l'homme du métier sans sortir du cadre de l'invention tel que défini par les revendications annexées. En particulier, il peut être envisagé comme alternative au fourreau 62 de soumettre le bracelet 1 selon l'invention à une seconde opération de surmoulage visant à recouvrir les deux bras 58, 60 ainsi que la partie médiane 6 qui les relie entre eux à l'aide d'une couche d'un second matériau plastique ou élastomère qui peut être le même ou différent du matériau utilisé pour la première couche de surmoulage 56. Egalement, comme illustré à la figure 6, la partie médiane 6 peut ne comprendre qu'une seule arche 78 pour supporter les pistes conductrices permettant de relier électriquement entre elles les première et seconde portions de circuit imprimé 4 et 28. On note également (voir figure 8) qu'une encoche 80 ménagée dans celui des éléments de guidage 44 qui ne reçoit pas le capteur de pression peut recevoir un guide de lumière transparent 82 sous lequel sera disposée une source de lumière ponctuelle 84 telle qu'une diode électroluminescente fixée sur la deuxième portion de circuit imprimé 10 et alimentée en courant par la source d'énergie électrique 38. Cette source de lumière ponctuelle 84 peut indiquer selon un code de couleur l'état de fonctionnement du capteur de pression 32. On note enfin que, par pression sur les boutons-poussoirs 39, il est par exemple possible de donner au microcontrôleur 30 l'ordre de commencer à mesurer la pression lors d'une plongée sous-marine ou bien de commander via le circuit intégré 40 le transfert des données relatives à une plongée sous-marine vers un appareil distant tel qu'un téléphone portable ou un ordinateur personnel. On notera que par une programmation adaptée du microcontrôleur 30, il est possible de permettre à celui-ci de faire la distinction par exemple entre une pression courte et une pression longue exercée sur le bouton-poussoir 39 ou entre une pression simple et une pression double. Si le bracelet 1 selon l'invention est équipé de deux boutons-poussoirs 39, il est même possible d'envisager d'utiliser des combinaisons de pressions sur ces deux boutons-poussoirs pour introduire des commandes dans le bracelet 1 selon l'invention.

### Nomenclature

Bracelet 1
Feuille de circuit imprimé 2
Première portion de circuit imprimé 4
Partie médiane 6
Arches 6a, 6b
Boîte de montre 8
Deuxième portion de circuit imprimé 10
Carrure 12
Fond 14
Insert 16
Anneau rigide 18
Mouvement horloger 20
Jeu d'aiguilles des heures 22a et des minutes 22b
Cadran 24
Glace 26
Troisième portion de circuit imprimé 28
Microcontrôleur 30
Capteur de pression 32
Accéléromètre 34
Capteur magnétique 36
Source d'énergie électrique 38
Bouton-poussoir 39
Circuit intégré 40
Paires de cornes 42
Eléments de guidage 44
Trou 46
Barrette 48
Logement 50
Augmentation de diamètre 52
Joint d'étanchéité 54
Première couche 56
Premier bras 58
Second bras 60
Fourreau 62
Premier brin 64
Second brin 66
Partie de raccordement 68
Ouverture 70
Bande supérieure 72
Bande inférieure 74
Bords périphériques 76
Arche 78
Encoche 80
Guide de lumière transparent 82
Source de lumière ponctuelle 84

## Revendications

1. Bracelet pour boîte de montre (8) comprenant un premier bras (58) dans lequel est logée une première portion de circuit imprimé (4) et un second bras (60), le premier bras (58) étant prolongé par une partie médiane (6) agencée pour se trouver sous la boîte de montre (8) et qui comprend une deuxième portion de circuit imprimé (10) reliée à la première portion de circuit imprimé (4) par des moyens de connexion électriques, la première portion de circuit imprimé (4) portant au moins une source d'énergie électrique (38) et un microcontrôleur (30) pour l'alimentation et la commande d'un capteur de pression (32), la partie médiane (6) étant coiffée par un insert (16) agencé pour servir de siège à la boîte de montre (8), un logement (50) dans lequel est agencé le capteur de pression (32) étant ménagé dans l'insert (16) et communiquant avec l'extérieur afin de permettre la mise en contact du capteur de pression (32) avec le milieu environnant, le capteur de pression (32) étant monté sur la deuxième portion de circuit imprimé (10) avec interposition d'un joint d'étanchéité (54) entre le logement (50) et la deuxième portion de circuit imprimé (10).

2. Bracelet selon la revendication 1, **caractérisé en ce que** l'insert (16) comprend deux éléments de guidage (44) agencés pour se placer entre deux paires de cornes (42) respectives portées par la boîte de montre (8), les éléments de guidage (44) étant percés chacun d'un trou (46) pour le passage d'une barrette (48) permettant de fixer le bracelet (1) à la boîte de montre (8), le logement (50) dans lequel est agencé le capteur de pression (32) étant ménagé dans l'un des éléments de guidage (44) et débouchant dans le trou (46) de passage de la barrette (48) correspondante, ce trou (46) présentant localement sur une partie de son périmètre un diamètre agrandi (52) par rapport au diamètre de la barrette (48) afin de permettre la mise en contact du capteur de pression (32) avec le milieu environnant,

3. Bracelet selon l'une quelconque des revendications 1 ou 2, **caractérisé en ce qu'**une troisième portion de circuit imprimé (28) logée dans le second bras (60) et portant au moins un autre composant électronique est reliée à la première portion de circuit imprimé (4) logée dans le premier bras (58) via la deuxième portion de circuit imprimé (10).

4. Bracelet selon la revendication 3, **caractérisé en ce que** les première, deuxième et troisième portions de circuit imprimé (4, 10, 28) sont faites d'un seul tenant.

5. Bracelet selon l'une quelconque des revendications 3 ou 4, **caractérisé en ce que** la partie médiane (6) comprend au moins une arche (76).

6. Bracelet selon l'une quelconque des revendications 3 à 5, **caractérisé en ce que** le premier bras (58) et le second bras (60) sont formés par la première portion de circuit imprimé (4) et la troisième portion de circuit imprimé (28) recouvertes d'une première couche de surmoulage (56).

7. Bracelet selon la revendication 6, **caractérisé en ce que** l'insert (16) est également recouvert par la première couche de surmoulage (56).

8. Bracelet selon l'une quelconque des revendications 6 ou 7, **caractérisé en ce que** le bracelet (1) qui est formé des première et troisième portions de circuit imprimé (4, 28) surmoulées au moyen de la première couche de surmoulage (56) et de la partie médiane (6) qui est coiffée par l'insert (16), est inséré dans un fourreau (62) formé d'un premier brin (64) et d'un second brin (66) reliés entre eux par une partie de raccordement (68), les premier et second brins (64, 66) étant creux et pourvus chacun d'une ouverture (70) afin de pouvoir y glisser les premier et second bras (58, 60).

9. Bracelet selon la revendication 8, **caractérisé en ce que** le fourreau (62) est formé d'une bande supérieure (72) et d'une bande inférieure (74) rendues solidaires l'une de l'autre selon leurs bords périphériques (76).

10. Bracelet selon l'une quelconque des revendications 6 ou 7, **caractérisé en ce que** le bracelet (1) est surmoulé au moyen d'un second matériau plastique ou élastomère.
